# EUROPEAN PATENT APPLICATION

(11) **EP 3 032 746 A2**
(43) Date of publication of application: **15.06.2016**
(21) Application number: 15195157.1
(22) Date of filing: 18.11.2015
(51) Int. Cl.: H03K 17/96

(54) **OPERATION DETECTION DEVICE FOR VEHICLE**

(30) Priority: 19.11.2014 JP 2014234139
(71) Applicant: AISIN SEIKI KABUSHIKI KAISHA, Kariya-shi, Aichi 448-8650 (JP)
(72) Inventor: HIROTA, Koichi, Kariya-shi, Aichi 448-8650 (JP); AIYAMA, Takaya, Kariya-shi, Aichi 448-8650 (JP); TAKAYANAGI, Hitoshi, Kariya-shi, Aichi 448-8650 (JP)
(74) Representative: TBK

(57) **Abstract**

An operation detection device (100) for a vehicle includes: a capacity measurement section (130) that measures a change amount of capacitance of an operation section; a determination section (110) that determines that there is an approaching operation of a user to the operation section if a state where an absolute value of a time change rate of the change amount of the capacitance is equal to or less than a second threshold value is continued for a first time after the change amount of the capacitance is equal to or greater than a first threshold value; and an output section (125) that outputs a control signal to an object to be controlled based on a determination result of the determination section.

## Description

### TECHNICAL FIELD

This disclosure relates to an operation detection device for a vehicle and, particularly, to a device for detecting a detected body based on a change of capacitance.

### BACKGROUND DISCUSSION

In the related art, a technique, in which a non-contact sensor of a capacitance type is provided in a door outside handle of a vehicle and unlocking and locking of a door are controlled based on a change amount of capacitance, has been developed. In such a technique, for example, if the hand of a user approaches or comes into contact with the non-contact sensor, and the like, the change in the capacitance is used and unlocking and locking of the door are controlled based on the change amount. However, for example, even if water droplets such as rainwater are attached to the non-contact sensor or a person passes through on the non-contact sensor side, the capacitance is changed and a malfunction of unlocking and locking of the door may occur.

In order to prevent such a malfunction, for example, in JP2006-344554A (Reference 1), a touch sensor for a door, in which two sensor electrodes are disposed in the handle, has been proposed. The touch sensor for the door accepts the change in the capacitance as an operation command if the capacitance of each of two sensor electrodes disposed in the handle is changed and a predetermined voltage is output.

In addition, in JP2010-34828A (Reference 2), a contact detection device detecting a change amount of the capacitance and a time when the capacitance is changed has been proposed. The contact detection device determines whether or not the change of the capacitance is accepted as the operation command based on the change amount of the capacitance and the time when the capacitance is changed.

However, in Reference 1, for example, if a region including the sensor electrodes is wiped during car washing, the capacitance of two sensor electrodes is momentarily changed and a malfunction may be caused. Furthermore, in Reference 2, for example, since a size of the capacitance that is detected by wiping the region including the sensor electrodes during car washing is similar to a size of the capacitance when a hand wearing a glove comes into contact with the region, a malfunction may be caused.

### SUMMARY

Thus, a need exists for an operation detection device for a vehicle in which a change in capacitance that may cause erroneous detection is excluded and erroneous detection is further reliably prevented.

An operation detection device for a vehicle according to a first aspect of this disclosure includes a capacity measurement section that measures a change amount of capacitance of an operation section; a determination section that determines that there is an approaching operation of a user to the operation section if a state where an absolute value of a time change rate of the change amount of the capacitance is equal to or less than a second threshold value is continued for a first time after the change amount of the capacitance is equal to or greater than a first threshold value; and an output section that outputs a control signal to an object to be controlled based on a determination result of the determination section.

In the operation detection device for a vehicle according to the first aspect of this disclosure, the determination section may determine that there is a separating operation of the user from the operation section if the change amount of the capacitance is less than a third threshold value that is equal to or less than the first threshold value and a negative time change rate is equal to or less than a fourth threshold value within a second time after a lapse of the first time.

In the operation detection device for a vehicle according to the first aspect of this disclosure, an absolute value of the fourth threshold value may be greater than an absolute value of the second threshold value.

In the operation detection device for a vehicle according to the first aspect of this disclosure, the determination section may not determine presence or absence of the operation of the user to the operation section if switching of a positive and negative sign of the time change rate is generated by equal to or greater than a predetermined number of times within a predetermined period of time.

In the operation detection device for a vehicle according to the first aspect of this disclosure, the determination section may determine presence or absence of the operation of the user if a state where the change amount of the capacitance is less than a fifth threshold value is continued for a third time after switching of the positive and negative sign of the time change rate is changed a predetermined number of times.

According to the aspects of this disclosure, the presence or absence of the operation of the user is determined depending on whether or not the change amount and the time change rate of the measured capacitance value satisfy predetermined conditions. Thus, a state other than when the user performs a predetermined operation to the operation section, for example, a state where erroneous detection such as unintentional contact with the operation section and attachment of water droplets to the operation section may be caused can be eliminated. Therefore, it is possible to further reliably prevent erroneous detection.

### BRIEF DESCRIPTION OF THE DRAWINGS

The foregoing and additional features and characteristics of this disclosure will become more apparent from the following detailed description considered with the reference to the accompanying drawings, wherein:
Fig. 1A is a block diagram illustrating a configuration of an operation detection device for a vehicle according to an embodiment of this disclosure;
Fig. 1 B is a block diagram illustrating a capacity measurement section illustrated in Fig. 1A;
Fig. 2 is a view illustrating an example of attaching positions of a capacitance sensor attached to the vehicle;
Fig. 3 is a sectional view of the capacitance sensor attached to an emblem;
Fig. 4A is a view illustrating a configuration of a capacitance sensor electrode according to the embodiment of this disclosure;
Fig. 4B is a sectional view that is taken along line IVB-IVB illustrated in Fig. 4A;
Fig. 4C is a schematic view illustrating detection of a capacity change by the capacitance sensor electrode illustrated in Fig. 4A;
Fig. 5 is a flowchart illustrating an operation detection process according to the embodiment of this disclosure;
Fig. 6 is a flowchart illustrating a hand touch operation detection process illustrated in Fig. 5;
Fig. 7 is a flowchart illustrating a detection process of a hand separating operation illustrated in Fig. 5;
Fig. 8A is a graph indicating a capacitance value that is changed in compliance with an operation of a capacitance sensor, Fig. 8B is a graph indicating a change amount of a capacity value of Fig. 8A, and Fig. 8C is a graph indicating a time change rate with respect to the change amount of Fig. 8B;
Fig. 9 is a flowchart illustrating a pulsation detecting process illustrated in Fig. 5; and
Fig. 10A is a graph indicating the capacitance value that is changed in compliance with the operation to the capacitance sensor, Fig. 10B is a graph indicating the change amount of the capacity value of Fig. 10A, Fig. 10C is a graph indicating the time change rate with respect to the change amount of Fig. 10B, and Fig. 10D is a graph indicating an operation detection state of a hand touch operation detection process and a hand separating operation detection process.

### DETAILED DESCRIPTION

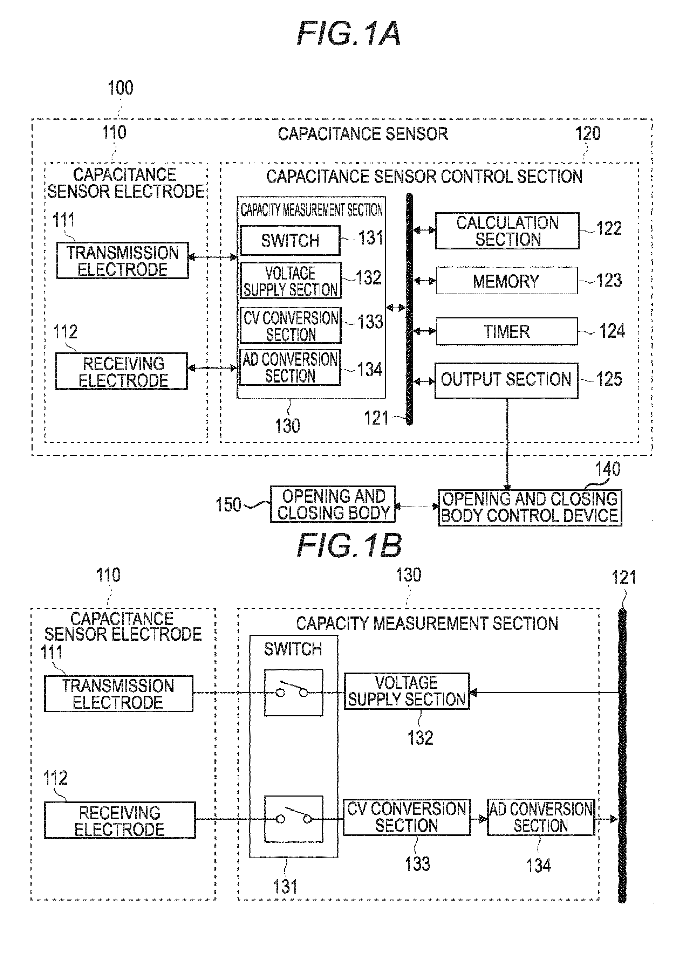

Hereinafter, an operation detection device for a vehicle according to an embodiment disclosed here will be described. Fig. 1A is a block diagram illustrating a configuration of the operation detection device for the vehicle. A capacitance sensor 100 that is the operation detection device for the vehicle is provided in a vehicle (not illustrated) and includes a capacitance sensor electrode 110 as a determination section and a capacitance sensor control section 120. The capacitance sensor electrode 110 is the determination section of the capacitance sensor 100 for detecting an operation of an opening and closing body for a vehicle by a user. The capacitance sensor control section 120 is a portion that controls the operation of the capacitance sensor electrode 110 and outputs a determination result by the capacitance sensor electrode 110 to an opening and closing body control device 140.

The capacitance sensor 100 of the embodiment is a mutual capacity type. The capacitance sensor electrode 110 includes a transmission electrode 111 and a receiving electrode 112. The transmission electrode 111 is an electrode for generating an electric force line by applying a voltage and the receiving electrode 112 is an electrode for receiving the electric force line. Thus, capacitance is generated between the transmission electrode 111 and the receiving electrode 112. A range in which the electric force line is generated is a detectable range of the capacitance sensor electrode 110. The capacitance sensor 100 of the embodiment detects approaching and separating of a detected object such as the hand of the user by measuring the capacitance value.

The capacitance sensor control section 120 includes a bus 121, a calculation section 122, a memory 123, a timer 124, an output section 125, and a capacity measurement section 130. The bus 121 is wiring connecting each part of the capacitance sensor control section 120. The capacity measurement section 130 is a portion for measuring the capacitance between the electrodes of the capacitance sensor electrode 110.

As the determination section, the calculation section 122 is, for example, a Central Processing Unit (CPU) and performs control of the capacitance sensor 100 by executing various programs stored in the memory 123. The calculation section 122 controls a measurement state of the capacity measurement section 130. For example, if a measurement of the capacitance is performed, a connection state of a switch 131 is switched by an output signal from the calculation section 122.

The memory 123 is formed of a ROM, a RAM, and the like, and is a storage medium for storing temporarily or permanently data such as an output value from the capacity measurement section 130, a time output from the timer 124, and a state of an opening and closing body 150 output from the opening and closing body control device 140. The memory 123 supplies data stored in compliance with an instruction from the calculation section 122. The timer 124 is a portion for performing supply of time information to each section.

The output section 125 as the output section is a portion serving as an interface that transmits and receives a signal between the capacitance sensor control section 120 and the opening and closing body control device 140. The output section 125 outputs a signal indicating that the detected object approaches the capacitance sensor electrode 110 and separates from the capacitance sensor electrode 110.

The opening and closing body control device 140 is, for example, an electronic control unit (ECU) mounted on the vehicle and controls an opening and closing operation of the opening and closing body 150 based on a signal input from the output section 125 of the capacitance sensor control section 120. The opening and closing body 150 is an opening and closing body for the vehicle that is controlled by the opening and closing body control device 140 and can automatically perform the opening and closing operation by a power source such as a motor. More particularly, the opening and closing body 150 may include a sliding door, a sunroof, a back door, a power window, and the like.

Fig. 1 B is a block diagram illustrating the capacity measurement section illustrated in Fig. 1A. The capacity measurement section 130 includes the switch 131, a voltage supply section 132, a Capacitance-to-Voltage (CV) conversion section 133 and an Analog-to-Digital (AD) conversion section 134.

The switch 131 switches ON/OFF of connection to the capacitance sensor electrode 110 in accordance with a control signal from the calculation section 122 input via the bus 121. The voltage supply section 132 is a portion for supplying a voltage for an output of the electric force line to the transmission electrode 111 in accordance with the control signal from the calculation section 122 input via the bus 121. The voltage supply section 132 may include a voltage conversion circuit, an amplification circuit, and the like for adjusting a voltage supplied to the transmission electrode 111.

The CV conversion section 133 is a CV conversion circuit that outputs a voltage value by converting the capacitance between the transmission electrode 111 and the receiving electrode 112 into the voltage value. The AD conversion section 134 is an AD conversion circuit that converts a voltage value that is an analog signal output from the CV conversion section 133 into a digital signal. A digital signal indicating a capacity value output from the AD conversion section 134 is held in the memory 123 via the bus 121. Moreover, in the embodiment, the CV conversion section 133 has a circuit performing measurement of the capacitance by the CV conversion circuit, but may perform the measurement of the capacitance by another method. For example, a capacitance measuring method may be applied by various circuits such as a circuit for repeatedly transmitting charge to a reference capacitor element and counting the number of times, and a CR resonant circuit.

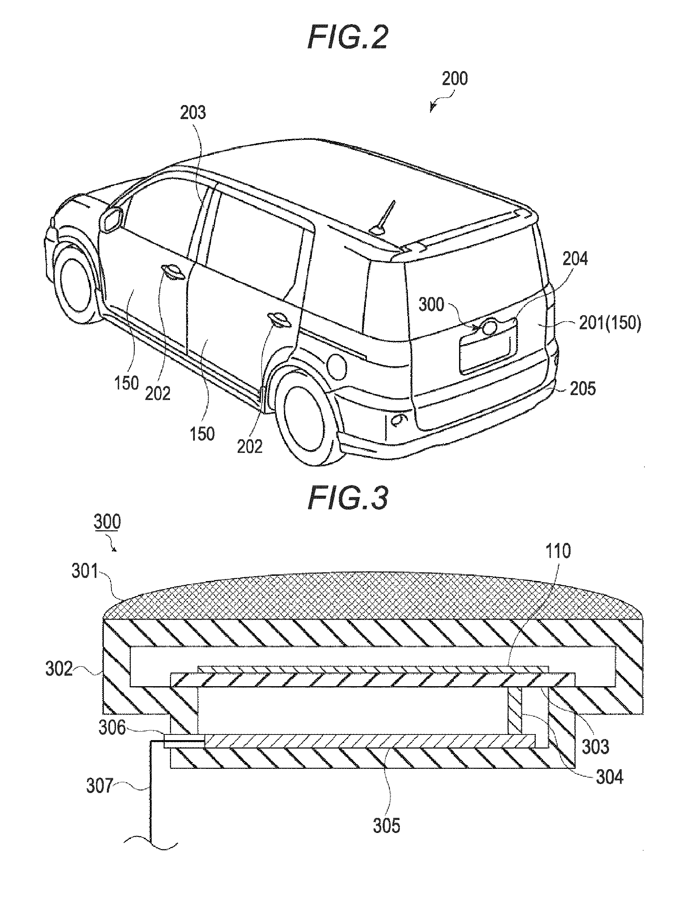

Fig. 2 is a view illustrating an example of attachment positions of the capacitance sensor electrode 110 attached to a vehicle 200. The capacitance sensor electrode 110 is built in an emblem 300 provided on an outer wall of a back door 201 as the opening and closing body 150 of the vehicle 200 as an example. In the example, the emblem 300 corresponds to the operation section. In addition, the attachment position of the capacitance sensor electrode 110 is not limited to the emblem 300 and may be provided in a position which is able to be operated by the user and in which the electric force line is not shielded by a conductor. For example, the capacitance sensor electrode 110 may be provided in a door handle 202, a center pillar (pillar that is positioned on a side surface of the vehicle and positioned between a front seat and a rear seat), a center pillar garnish 203, a belt mold (not illustrated), a back door garnish 204, a bumper 205, and the like. The capacitance sensor electrode 110 may be provided on a movable member of the opening and closing body 150 of the vehicle 200 or may be provided in a portion other than the movable member. In addition, the capacitance sensor electrode 110 may be provided on an inside of a portion that is not made of metal if a part of a member configuring the opening and closing body 150 is not made of metal.

Fig. 3 is a sectional view of the emblem 300 having the capacitance sensor electrode 110. The emblem 300 includes an exterior surface 301, a base section 302, a base body 303 in which the capacitance sensor electrode 110 is formed, a connection section 304, a control circuit substrate 305, a connector 306, and a harness 307.

A design indicating a manufacturer of the vehicle, a model of the vehicle, and the like is formed on the exterior surface 301. A main material of the exterior surface 301 is an insulator such as resin so as not to inhibit the electric force line output from the capacitance sensor electrode 110. In the base section 302, the exterior surface 301 is provided, the thin plate-shaped base body 303 in which the capacitance sensor electrode 110 is provided, the connection section 304, the control circuit substrate 305 are built in, and the base section 302 functions as a protective housing. The base body 303 is configured of a high-resistance material or an insulation material such as resin, glass, and ceramic.

The connection section 304 is a member electrically connecting the capacitance sensor electrode 110 and the control circuit substrate 305. The control circuit substrate 305 is a circuit component including an Integrated Circuit (IC) and the like. The control circuit substrate 305 may include a part or all of the functions of the capacitance sensor control section 120. The connector 306 is a member for connecting the control circuit substrate 305 to the harness 307 that is provided to input and output an electric signal to an outside of the base section 302. The harness 307 is connected to the ECU, a power supply, and the like of the vehicle.

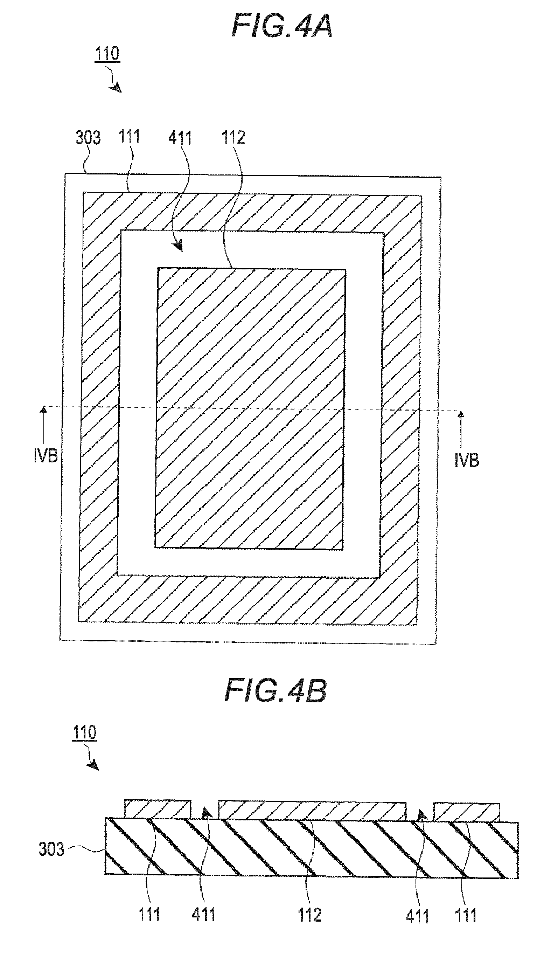

Fig. 4A is a view illustrating a configuration of the capacitance sensor electrode 110 according to the embodiment. Fig. 4B is a sectional view that is taken along line IVB-IVB illustrated in Fig. 4A of the capacitance sensor electrode 110. The transmission electrode 111 and the receiving electrode 112 of the capacitance sensor electrode 110 are formed on one main surface of the base body 303. The receiving electrode 112 is surrounded by the transmission electrode 111 via a gap 411.

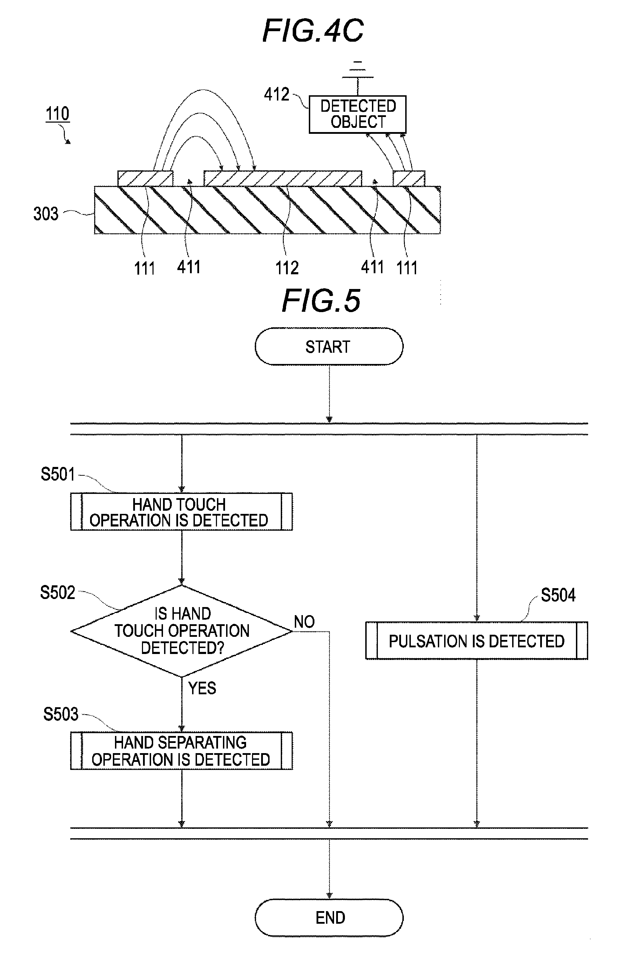

Fig. 4C is a schematic view illustrating detection of a capacity change by the capacitance sensor electrode 110 illustrated in Fig. 4A. A voltage is applied to the transmission electrode 111 and thereby the electric force line is transmitted from the transmission electrode 111. A part of the electric force line transmitted from the transmission electrode 111 is received in the receiving electrode 112. Thus, the capacitance is generated between the transmission electrode 111 and the receiving electrode 112.

If a detected object 412 as the detected body having conductivity such as the hand of the user approaches between the transmission electrode 111 and the receiving electrode 112, since the detected object 412 functions as an equivalent ground, the electric force line transmitted from the transmission electrode 111 is blocked by the detected object 412. Thus, the capacitance between the transmission electrode 111 and the receiving electrode 112 is reduced more than a case where the detected object 412 does not exist. It is possible to detect approaching of the detected object 412 and separating of the detected object 412 by measuring the reduction of the capacitance via the receiving electrode 112. Moreover, the electrode provided in the capacitance sensor electrode 110 or a detecting method of the capacitance sensor is arbitrary and may be appropriately changed.

Next, an operation detection process according to the embodiment will be described. Fig. 5 is a flowchart illustrating the operation detection process according to the embodiment. The flowchart illustrated in Fig. 5 is performed by executing each program by the calculation section 122 with a predetermined cycle.

In step S501, the calculation section 122 detects the presence or absence of a hand touch operation in which the hand of the user touches the capacitance sensor 100 based on a change amount of the capacitance of the capacitance sensor electrode 110 measured by the capacity measurement section 130. In step S502, the calculation section 122 determines whether or not the hand touch operation is detected in which the hand of the user touches the capacitance sensor electrode 110 in step S501. If the hand touch operation is detected (step S502: YES), the calculation section 122 determines that the hand touch operation is detected and the procedure proceeds to step S503. In step S503, the calculation section 122 detects the presence or absence of the hand separating operation in which the hand of the user separated from the capacitance sensor 100.

On the other hand, in step S502, if the hand touch operation is not detected (step S502: NO), the calculation section 122 determines that the hand of the user does not touch the capacitance sensor electrode 110 and the flowchart is completed.

The calculation section 122 executes step S504 parallel to steps S501 to S503. In step S504, the calculation section 122 detects an operation state to the capacitance sensor electrode 110 based on the change of the capacitance of the capacitance sensor electrode 110 measured by the capacity measurement section 130.

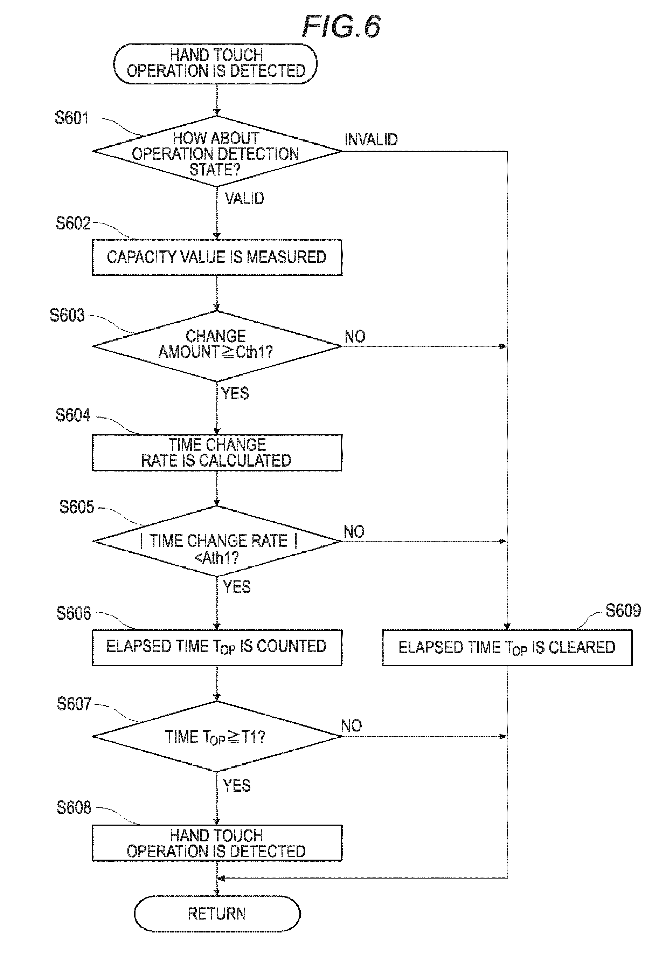

Next, the hand touch operation detection process will be described with reference to Fig. 6. Fig. 6 is a flowchart illustrating the hand touch operation detection process illustrated in Fig. 5.

In step S601, the calculation section 122 determines the operation detection state of the capacitance sensor 100. If the operation detection state of the capacitance sensor 100 is valid, the calculation section 122 determines that the operation determination can be performed based on the capacity value of the capacitance sensor electrode 110 measured by the capacity measurement section 130 and the procedure proceeds to step S602. On the other hand, if the operation detection state of the capacitance sensor 100 is invalid, the calculation section 122 determines that the operation determination cannot be performed based on the capacity value of the capacitance sensor electrode 110 measured by the capacity measurement section 130 and the procedure proceeds to step S609.

In step S602, the calculation section 122 calculates the capacity value of the capacitance sensor electrode 110. Particularly, the calculation section 122 inputs the control signal to the capacity measurement section 130 via the bus 121. The capacity measurement section 130 measures the capacity value of the capacitance sensor electrode 110 based on the control signal from the calculation section 122 and inputs the measured capacity value into the calculation section 122 via the bus 121. The calculation section 122 stores the measured capacity value in the memory 123.

In step S603, the calculation section 122 determines whether or not the change amount of the capacity value measured in step S602 is equal to or less a first threshold value Cₜₕ₁. The change amount is an absolute value of a difference between a measured value of the capacitance at a certain time and a capacity value of a case where the detected object 412 is not in a detectable range of the capacitance sensor electrode 110. That is, the change amount is a positive value. The first threshold value Cₜₕ₁ is a change amount in a state where the detected object 412 having conductivity approaches the capacitance sensor electrode 110 including a state where the hand of the user touches the capacitance sensor electrode 110.

If the change amount of the capacity value is equal to or greater than the first threshold value Cₜₕ₁ (step S603: YES), the calculation section 122 determines that the detected object 412 having conductivity approaches the capacitance sensor electrode 110 including a possibility that the detected object 412 is the hand of the user and the procedure proceeds to step S604. On the other hand, if the change amount of the capacity value is less than the first threshold value Cₜₕ₁ (step S603: NO), the calculation section 122 determines that the detected object 412 does not approach the capacitance sensor electrode 110 or the detected object 412 is not the hand of the user and the procedure proceeds to step S609.

In step S604, the calculation section 122 calculates a time change rate per unit time from the change amount of the capacity value measured in step S602. In step S605, the calculation section 122 determines whether or not an absolute value of the time change rate calculated in step S605 is less than a second threshold value Aₜₕ₁. The second threshold value Aₜₕ₁ is a change rate in a state where the detected object 412 is stopped within the detectable range of the capacitance sensor electrode 110. That is, if the time change rate calculated in step S604 is present within a range from -Aₜₕ₁ to Aₜₕ₁ that is the second threshold value, the change amount of the capacity value includes a state where the detected object 412 is stopped within the detectable range of the capacitance sensor electrode 110. If the absolute value of the time change rate is less than the second threshold value Aₜₕ₁ (step S605: YES), the calculation section 122 determines that the change amount of the capacity value is in a state where the detected object 412 is stopped within the detectable range of the capacitance sensor electrode 110 and the procedure proceeds to step S606. On the other hand, if the absolute value of the time change rate is equal to or greater than the second threshold value Aₜₕ₁ (step S605: NO), the calculation section 122 determines that the detected object 412 is moved within the detectable range of the capacitance sensor electrode 110 and the procedure proceeds to step S609.

In step S606, the calculation section 122 counts an elapsed time Tₒₚ after the absolute value of the time change rate is less than the second threshold value Aₜₕ₁. In step S607, the calculation section 122 determines whether or not the elapsed time Tₒₚ is equal to or greater than a first time T1. The first time T1 is a time during which a state where the hand of the user touches the capacitance sensor electrode 110 with intention to operate the opening and closing body 150 can be determined. If the elapsed time Tₒₚ is equal to or greater than the first time T1 (step S607: YES), the calculation section 122 determines that it is a state where the hand of the user touches the capacitance sensor electrode 110 and the procedure proceeds to step S608. If the elapsed time Tₒₚ is less than the first time T1 (step S607: NO), the calculation section 122 determines that it is a state where the hand of the user does not touch the capacitance sensor electrode 110 and the flowchart is completed.

In step S608, since a state where the change amount is equal to or less than the first threshold value and the time change rate is present within the range from -Aₜₕ₁ to Aₜₕ₁ that is the second threshold value is continued for the first time T1, the calculation section 122 determines that it is a state of including the hand touch operation in which the hand of the user touches the capacitance sensor electrode 110. Thus, it is possible to prevent erroneous detection due to a case where unintentional contact with the capacitance sensor electrode 110 occurs, the user passes through the detectable range of the capacitance sensor electrode 110, and the like.

In step S609, the calculation section 122 clears the elapsed time Tₒₚ and is returned to an initial state (for example, 0).

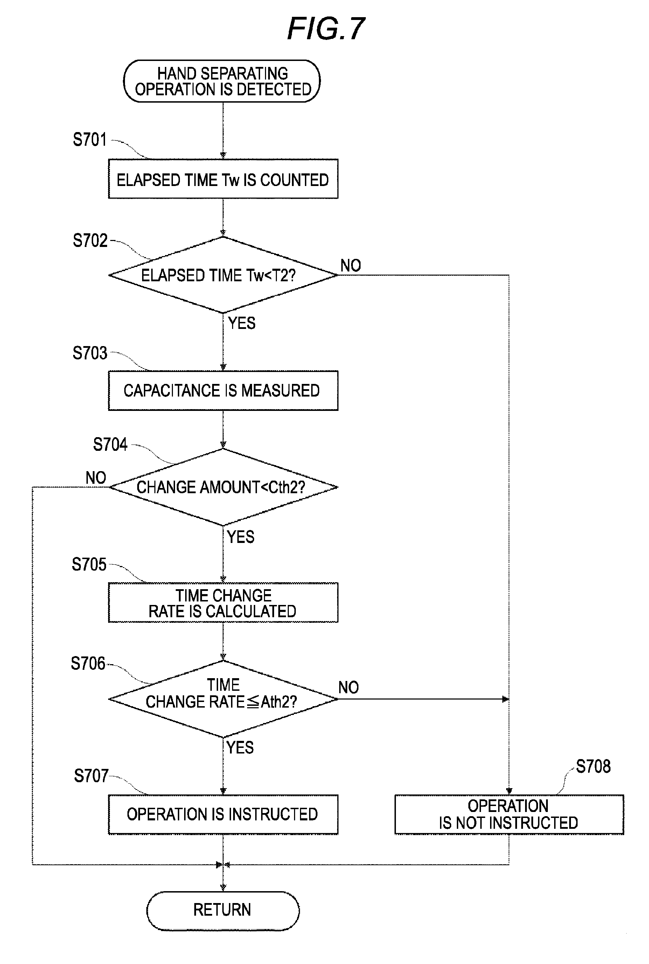

Next, the hand separating operation detection process will be described with reference to Fig. 7. Fig. 7 is a flowchart illustrating the hand separating operation detection process illustrated in Fig. 5.

In step S701, the calculation section 122 counts an elapsed time Tw after it is determined that the hand touch operation is detected in step S502. In step S702, the calculation section 122 determines whether or not the elapsed time Tw is less than a second time T2. A case where the hand of the user touches the capacitance sensor electrode 110 to intend to operate the opening and closing body 150 may be considered as an operation in which the hand of the user is stopped within the detectable range of the capacitance sensor electrode 110 for a predetermined period of time and then the hand is separated from the capacitance sensor electrode 110. That is, the user who is intended to operate the opening and closing body 150 touches the capacitance sensor electrode 110 with the hand and then the touched hand is separated from the capacitance sensor electrode 110. The second time T2 is an allowed time to be elapsed from determination of the hand touch operation being performed by the calculation section 122 to the generation of the change in the capacity value including separation of the hand of the user from the capacitance sensor electrode 110. It is possible to eliminate the change in the capacity value similar to the case that the user touches the capacitance sensor electrode 110 with the hand such as a case that the foreign materials are attached to the exterior surface 301 by determining whether or not the elapsed time is less than the second time T2.

If the elapsed time Tw is less than the second time T2 (step S702: YES), the calculation section 122 determines that the elapsed time Tw is within the allowed time and the procedure proceeds to step S703. If the elapsed time Tw is equal to or greater than the second time T2 (step S702: NO), the calculation section 122 determines that the elapsed time Tw exceeds the allowed time and the procedure proceeds to step S708.

In step S703, the calculation section 122 measures the capacity value of the capacitance sensor electrode 110. Sequentially, in step S704, the calculation section 122 determines whether or not the change amount of the capacity value measured in step S703 is less than a third threshold value Cₜₕ₂. The third threshold value Cₜₕ₂ is a change amount of a size that can be determined by the calculation section 122 if the detected object 412 is separated from the detectable range of the capacitance sensor electrode 110 including the state where the hand of the user is separated from the capacitance sensor electrode 110. If the change amount of the capacity value is less than the third threshold value Cₜₕ₂ (step S704: YES), the calculation section 122 determines that the detected object 412 is separated from the capacitance sensor electrode 110 and the procedure proceeds to step S705. On the other hand, if the change amount of the capacity value is equal to or greater than the third threshold value Cₜₕ₂ (step S704: NO), the calculation section 122 determines that the hand of the user touches the capacitance sensor electrode 110 and the flowchart is completed.

In step S705, the calculation section 122 calculates the time change rate per unit time from the change amount of the capacity value measured in step S703. In step S706, the calculation section 122 determines whether or not the time change rate calculated in step S705 is equal to or less than a fourth threshold value Aₜₕ₂. The fourth threshold value Aₜₕ₂ is a change rate of a case where the hand of the user is separated from the detectable range of the capacitance sensor electrode 110. The fourth threshold value Aₜₕ₂ does not include a time change rate of a case where the capacity value is slowly changed even if the hand of the user is separated, for example, such a case where water droplets attached to the exterior surface 301 of the emblem 300 are dried. In addition, it is preferable that an absolute value of the fourth threshold value Aₜₕ₂ is greater than an absolute value of the second threshold value Aₜₕ₁.

If the time change rate is equal to or less than the fourth threshold value Aₜₕ₂ (step S706: YES), the calculation section 122 determines that the hand of the user is separated from the capacitance sensor electrode 110 and the procedure proceeds to step S707. On the other hand, if the time change rate is greater than the fourth threshold value Aₜₕ₂ (step S706: NO), the calculation section 122 determines that the calculated time change rate is not the change rate due to separation of the hand of the user and the procedure proceeds to step S708. Thus, for example, it is possible to exclude the change amount of the capacity value having a possibility of causing the erroneous detection such as the change in the capacity value, for example, due to drying of the water droplets attached to the exterior surface 301 of the emblem 300.

In step S707, the calculation section 122 determines that there is an operation instruction to the opening and closing body 150 and transmits the control signal indicating that there is the operation instruction to the opening and closing body control device 140. Then, the elapsed time Tw is cleared and is returned to the initial value (for example, 0).

In step S708, the calculation section 122 determines that the change amount of the capacity value indicating that the hand is separated is not present even if the elapsed time Tw is over or the detected object 412 is not the hand of the user, the elapsed time Tw is cleared, and is returned to the initial value (for example, 0). As described above, presence or absence of the operation instruction to the opening and closing body 150 is determined by excluding the change amount of the capacity value having the possibility of causing the erroneous detection based on the change amount of the capacity value detected by the capacitance sensor electrode 110 by performing the hand touch operation detection process and the hand separating operation detection process. Thus, it is possible to further reliably prevent the erroneous detection based on the capacity value detected by the capacitance sensor electrode 110.

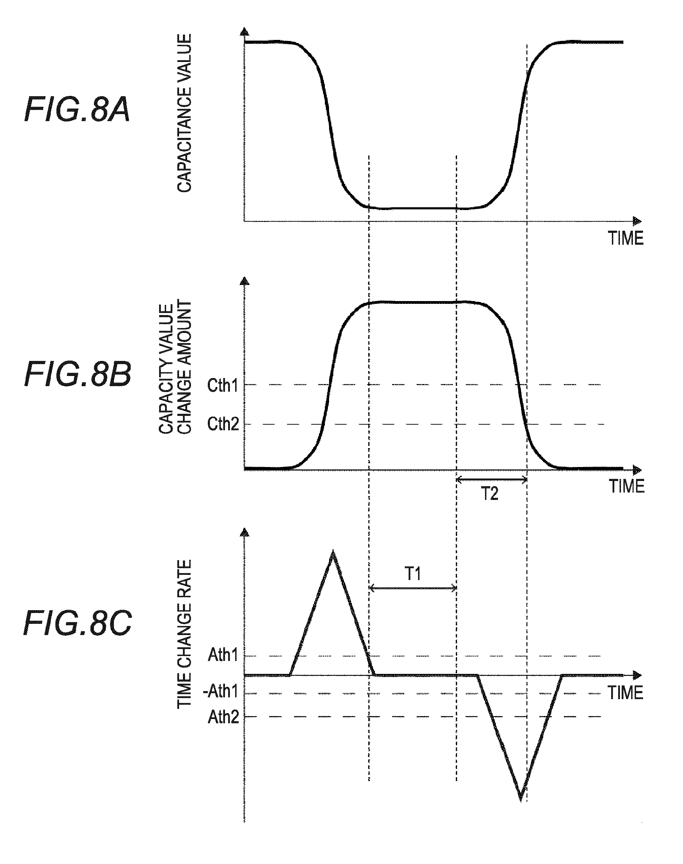

The determination of the operation instruction to the opening and closing body 150 will be described with reference to Figs. 8A to 8C. Fig. 8A is a graph indicating the capacitance value that is changed in compliance with the operation of the capacitance sensor, Fig. 8B is a graph indicating the change amount of the capacity value of Fig. 8A, and Fig. 8C is a graph indicating the time change rate with respect to the change amount of Fig. 8B.

As illustrated in Fig. 8A, in the embodiment, since the capacitance sensor 100 of the mutual capacity type is used, the capacity value of a case where the detected object 412 is not present in the detectable range of the capacitance sensor electrode 110 is the largest. In the capacitance sensor 100, the capacity value is reduced as the detected object 412 is present in the detectable range of the capacitance sensor electrode 110.

If the hand of the user closes to the detectable range of the capacitance sensor electrode 110, the change amount of the capacity value is increased. The time change rate with respect to the change amount of the capacity value becomes a substantially inverted V-shape in which the change amount of the capacity value is changed in a positive direction so as to be increased. If the hand of the user closes to and touches the detectable range of the capacitance sensor electrode 110, the hand of the user is in a substantially stopped state, the change amount of the capacity value of this case is greater than the first threshold value Cₜₕ₁, and becomes a relatively stable change amount. If a period of time when the change amount of the capacity value becomes the relatively stable change amount, that is, a state where the time change rate is within a range from -Aₜₕ₁ to Aₜₕ₁ that is the second threshold value is continued for the first time T1, the change amount of the capacity value includes a state where the hand of the user touches the detectable range of the capacitance sensor electrode 110.

If the hand of the user is separated from the detectable range of the capacitance sensor electrode 110, the change amount of the capacity value is decreased. After the first time T1 is elapsed, if the change amount of the capacity value is less than the third threshold value Cₜₕ₂ and at this time, the time change rate of the change amount of the capacity value is equal to or less than the fourth threshold value Aₜₕ₂ within the second time T2, it may be regarded as the hand of the user is separated from the detectable range of the capacitance sensor electrode 110. Moreover, it is preferable that the first threshold value Cₜₕ₁ is set to be equal to or greater than the third threshold value Cₜₕ₂, that is, hysteresis is provided.

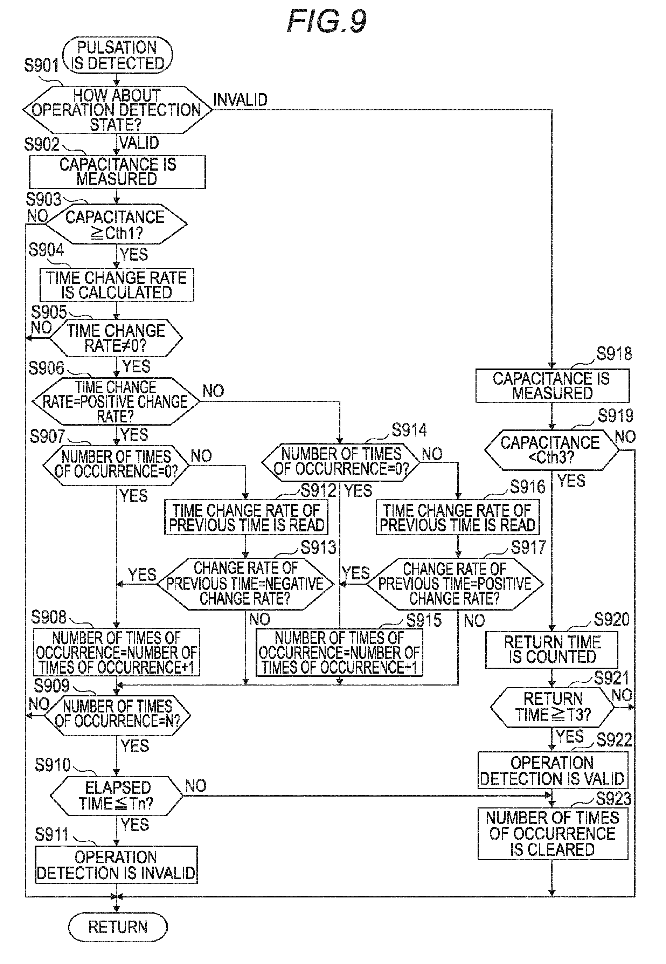

Next, a pulsation detecting process will be described. Fig. 9 is a flowchart illustrating the pulsation detecting process illustrated in Fig. 5.

In step S901, the calculation section 122 determines the operation detection state of the capacitance sensor 100. If the detection state of the capacitance sensor 100 is valid, the calculation section 122 determines that the operation detection of the capacitance sensor 100 can be performed and the procedure proceeds to step S902. If the detection state of the capacitance sensor 100 is invalid, the calculation section 122 determines that the operation detection of the capacitance sensor 100 is not performed and the procedure proceeds to step S918.

In step S902, the calculation section 122 measures the capacity value of the capacitance sensor electrode 110 and stores the capacity value in the memory 123. In step S903, the calculation section 122 determines whether or not the change amount of the capacity value measured in step S902 is equal to or greater than the first threshold value Cₜₕ₁. If the change amount of the capacity value is equal to or greater than the first threshold value Cₜₕ₁ (step S903: YES), it is determined that the detected object 412 having conductivity including a possibility that the detected object is the hand of the user closes to the capacitance sensor electrode 110 and the procedure proceeds to step S904. If the change amount of the capacity value is less than the first threshold value Cₜₕ₁ (step S903: NO), it is determined that the detected object 412 does not close to the capacitance sensor electrode 110 or the detected object 412 is not the hand of the user and the flowchart is completed.

In step S904, the calculation section 122 calculates the time change rate with respect to the change amount of the capacitance measured in step S902 and stores the time change rate in the memory 123. In step S905, the calculation section 122 determines whether or not the time change rate calculated in step S904 is other than 0. If the time change rate is not 0 (step S905: YES), the calculation section 122 determines that the detected object 412 is present within the detectable range of the capacitance sensor electrode 110 and the procedure proceeds to step S906. If the time change rate is 0, the calculation section 122 determines that the capacity value is not changed and the flowchart is completed.

In step S906, the calculation section 122 determines whether or not the time change rate calculated in step S904 is a positive change rate. If the time change rate is the positive change rate (step S906: YES), the calculation section 122 determines that the time change rate is changed in a range of the positive value and the procedure proceeds to step S907. If the time change rate is not the positive change rate (step S906: NO), the calculation section 122 determines that a positive and negative sign of the time change rate is not changed and the procedure proceeds to step S914.

In step S907, the calculation section 122 determines whether or not the number of times of occurrence of a change of the time change rate to a positive side or a negative side is 0. The number of times of occurrence is the number of times in which the time change rate is alternately changed so as to pulsate from the positive side to the negative side or from the negative side to the positive side. If the number of times of occurrence is 0 (step S907: YES), the calculation section 122 determines that the time change rate is not changed to the positive side or to the negative side, starts measurement of the elapsed time using the timer 124, and the procedure proceeds to step S908. If the number of times of occurrence is not 0 (step S907: NO), the calculation section 122 determines that the time change rate is already changed to the positive side or to the negative side and the procedure proceeds to step S912.

In step S908, the calculation section 122 performs increments of the number of times of occurrence. Sequentially, in step S909, the calculation section 122 determines whether or not the number of times of occurrence is a predetermined number of times N. The predetermined number of times N is the number of times which is a threshold value allowing the operation detection state of the capacitance sensor 100 to be invalid.

As a case where the operation detection state of the capacitance sensor 100 is invalid, for example, a case where the user wipes the exterior surface 301 of the emblem 300 with a cloth after washing the vehicle 200 and the like may be considered. If the user wipes a region including the exterior surface 301 with, for example, a dried cloth to wipe the water droplets attached to the exterior surface 301, the user wipes the water droplets with the cloth while reciprocating the exterior surface 301 several times. In this case, the time change rate calculated by the calculation section 122 transits to the positive side and the negative side with a cycle shorter than that of a case where the hand of the user touches and separates from the capacitance sensor electrode 110. As described above, the time change rate transiting to the positive side and the negative side with a short cycle is different from the change in the time change rate that is generated by a case where the hand of the user touches the capacitance sensor electrode 110 to intend to operate the opening and closing body 150. If the operation, in which the time change rate is changed to the positive side and the negative side with the short cycle, is performed, the operation detection process indicated in steps S501 to S503 is performed to include a possibility of the erroneous detection by the calculation section 122. Thus, if the time change rate transits to the positive side and the negative side with the short cycle, it is possible to prevent the erroneous detection by allowing the operation detection state to be invalid.

If the number of times of occurrence is the predetermined number of times N (step S909: YES), the calculation section 122 determines that the number of times of occurrence that is alternately changed to the positive side and the negative side of the time change rate is the number of times of occurrence that allows the operation detection of the capacitance sensor 100 to be invalid and the procedure proceeds to step S911. If the number of times of occurrence is not the predetermined number of times N (step S909: NO), the calculation section 122 determines that the number of times that is alternately changed to the positive side and the negative side of the time change rate is not the number of times that allows the operation detection of the capacitance sensor 100 to be invalid and the flowchart is completed.

In step S910, the calculation section 122 determines whether or not the elapsed time from when the number of times of occurrence is changed from 0 to 1 is equal to or less than a predetermined time Tn. The predetermined time is a period of time in which a state, where the change in the capacity value is provided by repeatedly generating the time change rate of the cycle shorter than the cycle of the time change rate that, for example, the user touches and separates from the exterior surface 301 with hand by the predetermined number of times, is capable of being recognized.

If the elapsed time is within the predetermined time Tn (step S910: YES), since the number of times of occurrence becomes N within the predetermined time Tn, the calculation section 122 determines that the capacity value is not changed by the operation of the user and the procedure proceeds to step S911. If the elapsed time exceeds the predetermined time Tn (step S910: NO), since the number of times of occurrence becomes N beyond the predetermined time Tn, the calculation section 122 determines that it is a state of including the change in the capacity value by the operation of the user and the procedure proceeds to step S923. As described above, it is determined whether or not the number of times of occurrence N is generated within the predetermined time Tn and thereby it is possible to exclude a case of reaching the predetermined number of times N by accumulating the number of times of occurrence of the change in the capacity value by the hand touch operation or the hand separating operation of the user, for example.

In step S911, the calculation section 122 allows the operation detection of the capacitance sensor 100 to be invalid. For example, the calculation section 122 may set a flag indicating invalidity in the operation detection state of the capacitance sensor 100.

In step S912, since the time change rate transits to the positive side or the negative side, the calculation section 122 reads the time change rate that is stored in the previous time from the memory 123. Sequentially in step S913, the calculation section 122 determines whether or not the time change rate of the previous time is on the negative side. If the time change rate of the previous time is on the negative side (step S913: YES), the calculation section 122 determines that the sign of the time change rate is changed from the negative side to the positive side and the procedure proceeds to step S908. If the time change rate of the previous time is on the positive side (step S913: NO), the calculation section 122 determines that the sign of the time change rate of the previous time is not changed and the procedure proceeds to step S909.

In step S914, the time change rate calculated in step S904 is a value on the negative side and the calculation section 122 determines whether or not the number of times of occurrence, in which the time change rate is changed to the positive side or the negative side, is 0. If the number of times of occurrence is 0 (step S914: YES), the calculation section 122 determines that the time change rate is not changed to the positive side or the negative side and starts measurement of the elapsed time using the timer 124, and the procedure proceeds to step S915. If the number of times of occurrence is not 0 (step S914: NO), the calculation section 122 determines that the time change rate is already changed to the positive side or the negative side and the procedure proceeds to step S916. In step S915, the calculation section 122 performs increments of the number of times of occurrence.

In step S916, the calculation section 122 reads the time change rate stored in the previous time from the memory 123. Sequentially, in step S917, the calculation section 122 determines whether or not the time change rate of the previous time that is read in step S916 is the positive change rate. If the time change rate of the previous time is the positive change rate (step S917: YES), the calculation section 122 determines that the sign is changed from the negative time change rate that is the time change rate of the previous time to the positive change rate that is the time change rate obtained in the current step S904, and the procedure proceeds to step S915. If the time change rate of the previous time is the negative time change rate (step S917: NO), the calculation section 122 determines that the sign is not changed from the time change rate of the previous time and the procedure proceeds to step S909.

In step S918, the calculation section 122 measures the capacity value of the capacitance sensor electrode 110 and stores the capacity value in the memory 123. In step S919, the calculation section 122 determines whether or not the change amount of the capacity value measured in step S918 is less than a fifth threshold value Cₜₕ₃. The fifth threshold value Cₜₕ₃ is a change amount of a case where the detected object 412 is not present within the detectable range of the capacitance sensor electrode 110. If the change amount of the capacity value is less than the fifth threshold value Cₜₕ₃ (step S919: YES), the calculation section 122 determines that the detected object 412 is separated from the detectable range of the capacitance sensor electrode 110 and the procedure proceeds to step S920. If the change amount of the capacity value is equal to or greater than the fifth threshold value Cₜₕ₃ (step S919: NO), the calculation section 122 determines that the detected object 412 is present in the detectable range of the capacitance sensor electrode 110 and the flowchart is completed. Moreover, the fifth threshold value Cₜₕ₃ may be equal to the third threshold value Cₜₕ₂.

In step S920, since the operation detection state of the capacitance sensor 100 is invalid, the calculation section 122 counts a return time for allowing the operation detection state of the capacitance sensor 100 to be valid. In step S921, the calculation section 122 determines whether or not the return time counted in step S920 is equal to or greater than a third time T3. The third time T3 is a period of time in which the change in the capacity value having a possibility of causing the erroneous detection of the capacitance sensor 100 does not occur. If the return time is equal to or greater than the third time T3 (step S921: YES), the calculation section 122 determines that a state where the change amount of the capacity value is less than the fifth threshold value Cₜₕ₃ is continuous for the third time T3 or more and the procedure proceeds to step S922. If the return time is less than the third time T3 (step S921: NO), the calculation section 122 determines that a state where the change amount of the capacity value is less than the fifth threshold value Cₜₕ₃ is less than the third time T3 and the flowchart is completed.

In step S922, since the change in the capacity value having the possibility of causing the erroneous detection does not occur, the calculation section 122 allows the operation detection state of the capacitance sensor 100 to be in a valid state. Thus, after a period in which the change in the capacity value having the possibility of causing the erroneous detection occurs, it is possible to perform the operation detection of the capacitance sensor 100 based on the capacity value detected by the capacitance sensor electrode 110 again.

In step S923, the number of times of occurrence in which the time change rate is changed to the positive side and the negative side is cleared and is returned to the initial value (for example, 0). Furthermore, the return time is also cleared and is returned to the initial value (for example, 0).

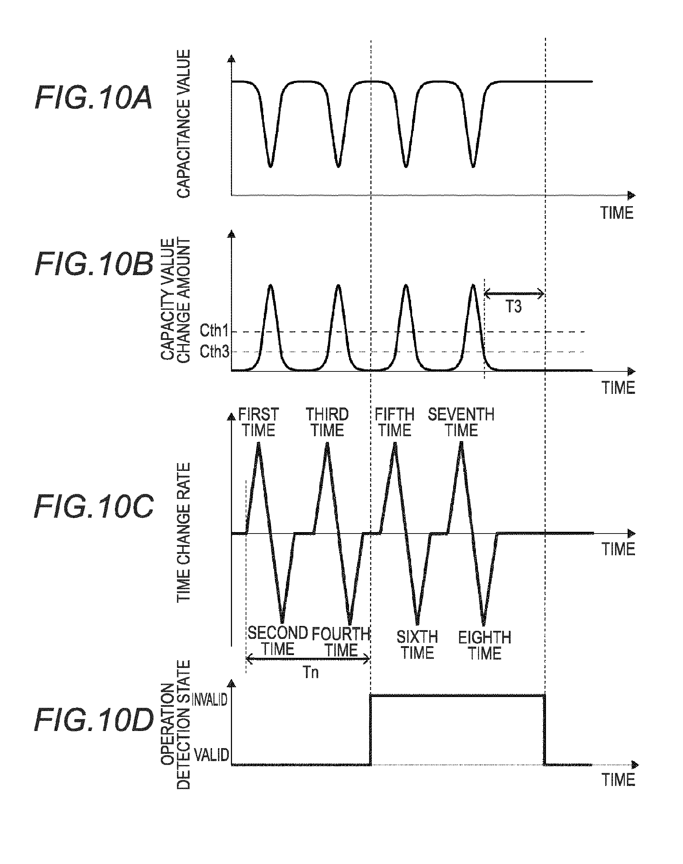

Pulsation detection will be described with reference to Figs. 10A to 10D. Fig. 10A is a graph indicating the capacitance value that is changed in compliance with the operation to the capacitance sensor, Fig. 10B is a graph indicating the change amount of the capacity value of Fig. 10A, Fig. 10C is a graph indicating the time change rate with respect to the change amount of Fig. 10B, and Fig. 10D is a graph indicating the operation detection state of the hand touch operation detection process and the hand separating operation detection process.

For example, after the user washes the vehicle 200, if the exterior surface 301 of the emblem 300 is wiped with the dry cloth, the capacitance sensor electrode 110 detects the cloth as the detected object 412. For example, if the user wipes the exterior surface 301 of the emblem 300 with the cloth while reciprocating the exterior surface 301, as illustrated in Fig. 10A, the capacitance value is periodically changed. As illustrated in Fig. 10C, the time change rate is changed from the negative time change rate to the positive change rate in a period of time shorter than the case where the user touches the capacitance sensor electrode 110 with the hand in compliance with the change in the capacitance value of Fig. 10A.

In Fig. 10C, the calculation section 122 allows the positive change rate that is initially present to be the number of times of occurrence of a first time, the negative time change rate that is transited from the positive change rate to be the number of times of occurrence of a second time, and counts the number of times of occurrence whenever the signal of the time change rate is changed. Then, for example, when the number of times of occurrence of the first time is counted, measurement of the elapsed time is started by the timer 124. For example, if the predetermined number of times N is 4, the number of times of occurrence of a fourth time is counted, and at this time, the elapsed time is within the predetermined time Tn, as illustrated in Fig. 10D, the operation detection state of the capacitance sensor 100 is invalid. After the operation detection state is invalid, a state where the change amount of the capacity value is less than the fifth threshold value Cₜₕ₃ is continuous for the third time T3 or more, the operation detection state is valid. The calculation section 122 does not perform the operation detection based on the capacity value present in a period in which the operation detection state is invalid and the time change rate in the number of times of occurrence of a fifth time to an eighth time. As described above, it is possible to further reliably prevent the erroneous detection by allowing the operation detection with respect to the change in the capacity value of a case where the user does not intend to operate the opening and closing body 150 to be invalid.

As described above, in the embodiment, after the change amount of the capacity value calculated by the calculation section 122 is equal to or greater than the first threshold value Cₜₕ₁ indicating approach of the detected object 412, if a state where the absolute value of the time change rate with respect to the change amount of the capacity value is equal to or less than the second threshold value Aₜₕ₁ indicating the stop state of the detected object 412 is continuous for the first time T1, it is determined that the approaching operation to the capacitance sensor electrode 110 is present. Thus, a state other than when the user performs a predetermined operation to the capacitance sensor electrode 110, for example, a state where erroneous detection such as unintentional contact with the capacitance sensor electrode 110 and attachment of water droplets to the capacitance sensor electrode 110 may be caused can be eliminated.

Although description of the embodiment is concluded, the disclosure is not limited to the above-described embodiment and various modifications are possible without departing from the scope of the disclosure. For example, in the above-described embodiment, the capacitance sensor of the mutual capacity type is described, but the disclosure may be applied to a capacitance sensor of a self-capacity type.

Furthermore, in the above-described embodiment, detection of the hand operation of the user is described, but, for example, the disclosure can be applied to a case where the user performs the operation to the capacitance sensor electrode 110 with the shoulders, back, and the like if the hand of the user is blocked.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

An operation detection device (100) for a vehicle includes: a capacity measurement section (130) that measures a change amount of capacitance of an operation section; a determination section (110) that determines that there is an approaching operation of a user to the operation section if a state where an absolute value of a time change rate of the change amount of the capacitance is equal to or less than a second threshold value is continued for a first time after the change amount of the capacitance is equal to or greater than a first threshold value; and an output section (125) that outputs a control signal to an object to be controlled based on a determination result of the determination section.

## Claims

1. An operation detection device (100) for a vehicle, comprising:
a capacity measurement section (130) that measures a change amount of capacitance of an operation section;
a determination section (110) that determines that there is an approaching operation of a user to the operation section if a state where an absolute value of a time change rate of the change amount of the capacitance is equal to or less than a second threshold value is continued for a first time after the change amount of the capacitance is equal to or greater than a first threshold value; and
an output section (125) that outputs a control signal to an object to be controlled based on a determination result of the determination section.

2. The operation detection device for a vehicle according to claim 1,
wherein the determination section determines that there is a separating operation of the user from the operation section if the change amount of the capacitance is less than a third threshold value that is equal to or less than the first threshold value and a negative time change rate of the change amount of the capacitance is equal to or less than a fourth threshold value within a second time after a lapse of the first time.

3. The operation detection device for a vehicle according to claim 2,
wherein an absolute value of the fourth threshold value is greater than an absolute value of the second threshold value.

4. The operation detection device for a vehicle according to any one of claims 1 to 3,
wherein the determination section does not determine presence or absence of the operation of the user to the operation section if switching of a positive and negative sign of the time change rate is generated by equal to or greater than a predetermined number of times within a predetermined period of time.

5. The operation detection device for a vehicle according to claim 4,
wherein the determination section determines presence or absence of the operation of the user if a state where the change amount of the capacitance is less than a fifth threshold value is continued for a third time after switching of the positive and negative sign of the time change rate is changed a predetermined number of times.
